# EUROPEAN PATENT SPECIFICATION

(11) **EP 0 490 368 B1**
(45) Date of publication and mention of the grant of the patent: **21.05.1997**
(21) Application number: 91121268.6
(22) Date of filing: 11.12.1991
(51) Int. Cl.: G03F 7/027, G03F 7/075

(54) **PS plate requiring no dampening water**
Vorsensibilisierte wasserlose Platte
Plaque présensibilisée à sec

(30) Priority: 13.12.1990 JP 401865/90
(43) Date of publication of application: 17.06.1992
(73) Proprietor: Fuji Photo Film Co., Ltd., Kanagawa-ken (JP)
(72) Inventor: Abe, Yukio, c/o FUJI PHOTO FILM CO., LTD., Haibara-gun, Shizuoka-ken (JP); Higashi, Tatsuji, c/o FUJI PHOTO FILM CO., LTD., Haibara-gun, Shizuoka-ken (JP); Hirano, Tsumoru, c/o FUJI PHOTO FILM CO., LTD., Haibara-gun, Shizuoka-ken (JP)
(74) Representative: Grünecker, Kinkeldey, Stockmair & Schwanhäusser Anwaltssozietät

(56) References cited:
- EP-A- 0 386 777
- PATENT ABSTRACTS OF JAPAN, vol. 11, no. 243 (P-603)(2690) 8 August 1987 & JP-A-62 052 547

## Description

### SPECIFICATION

### BACKGROUND OF THE INVENTION

The present invention relates to a presensitized plate requiring no dampening water suitable for use in making a lithographic printing plate requiring no dampening water which permits the printing without using any dampening water.

There have been proposed various kinds of presensitized plate requiring no dampening water (hereinafter referred to as "PS plate requiring no dampening water") for use in making a lithographic printing plate which can provide copies without using any dampening water (hereinafter referred to as "lithographic printing plate requiring no dampening water"). Among these, those disclosed in Japanese Patent Publication for Opposition Purpose (hereinafter referred to as "J.P. KOKOKU") Nos. Sho 54-26923 and Sho 55-22781 comprise a substrate provided thereon with, in order, a light-sensitive resin layer and a silicone rubber layer and exhibit very excellent quality.

The silicone rubber layer used in these PS plates requiring no dampening water is currently formed by partially crosslinking a polymer mainly comprising a polysiloxane skeleton with a crosslinking agent. The silicone rubber layer is in general hardened by either of the following two methods.
(1) A condensing method in which an organopolysiloxane having hydroxyl groups on both ends is crosslinked with a silane or siloxane carrying a hydrolyzable functional group directly bonded to the silicon atom to give a silicone rubber layer.
(2) An addition method in which a polysiloxane having ≡ Si-H groups is subjected to an addition reaction with a polysiloxane carrying -CH=CH- groups to give a silicone rubber layer (see, for instance, Japanese Unexamined Patent Publication (hereinafter referred to as "J.P. KOKAI") No. Sho 61-73156 and Japanese Patent Application Serial Number (hereinafter referred to as "J.P.A. No.") Hei 1-301568 (=J.P. KOKAI No. Hei 3-161753).

The hardening ability and the adhesion to a light-sensitive layer of the condensed silicone rubber (1) are greatly affected by the moisture content of the atmosphere during hardening. Therefore, if the condensed silicone rubber layer is used, the resulting PS plate requiring no dampening water does not show stable quality such as sensitivity. For this reason, the addition type silicone rubber (2) seems to be superior to the condensed type one since the former does not suffer from such a problem.

A photopolymerizable light-sensitive composition which is hardened through exposure to light is generally used for forming a light-sensitive resin layer of positive-working PS plates. Images are in general formed on these PS plates having such a layer structure in the following manner. The light-sensitive resin layer thereof is first hardened by exposing to light or optionally photoadhering the light-sensitive layer to the upper most silicone rubber layer at the interface therebetween to thus firmly adhere these two layers to one another. Thus, a developer cannot penetrate into the light-sensitive resin layer exposed to light and accordingly the exposed portion is not dissolved out by the developer. As a result, the silicone rubber layer remaining on the PS plate serves as a non-image area. On the other hand, image areas are formed by permeating the developer into the light-sensitive resin layer through the silicone rubber layer to thus dissolve out a part or whole of the unhardened light-sensitive resin layer and then removing the silicone rubber layer on the unhardened light-sensitive resin layer by the application of a physical force. However, there has not yet been proposed any PS plate requiring no dampening water which has sufficient sensitivity practically acceptable and excellent developability.

### SUMMARY OF THE INVENTION

Accordingly, the object of the present invention is to provide a PS plate requiring no dampening water which has high sensitivity and excellent developability.

The inventors of this invention have found out that a PS plate requiring no dampening water having excellent sensitivity and developability can be obtained if the PS plate which comprises a substrate provided thereon with, in order, a light-sensitive resin layer and a silicone rubber layer comprises a specific photopolymerizable monomer incorporated into the light-sensitive resin layer and thus have completed the present invention.

According to the present invention, the foregoing object can effectively be achieved by providing a PS plate requiring no dampening water which comprises a substrate, a light-sensitive resin layer applied onto the substrate and a silicone rubber layer formed on the light-sensitive resin layer through an addition reaction of ≡ Si-H groups with -CH=CH- groups wherein the light-sensitive resin layer is formed from a light-sensitive composition comprising the following components:
1) at least one monomer represented by the following general formula (I):

   R²O(CH₂CH(R¹)O) ₙ R³ (I)

   wherein R¹ represents a hydrogen atom or a methyl group; R² and R³ may be the same or different and each represents a functional group selected from the group consisting of those represented by the following general formula (II): 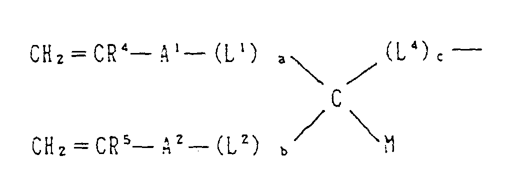 wherein M represents a hydrogen atom, a monovalent functional group or a group: CH₂=CR⁶-A³-(L³) _{d} -; R⁴, R⁵ and R⁶ may be the same or different and each represents a hydrogen atom or a methyl group; A¹, A² and A³ may be the same or different and each represents -CO-O-, -CO-NH- or a substituted or unsubstituted phenylene group; L¹, L², L³ and L⁴ may be the same or different and each represents a bivalent connecting group; a, b, c and d may be the same or different and each represents 0 or 1 and n is an integer of not less than 1;
2) a photopolymerization initiator; and
3) a polymeric compound having film-forming ability.

### DESCRIPTION OF THE PREFERRED EMBODIMENTS

The present invention will hereunder be explained in more detail.

The PS plate requiring no dampening water must have flexibility sufficient for putting it on the usual printing press and must withstand the load applied thereto during printing. For this reason, typical substrates include, for instance, coated paper, metal plates such as aluminum plates, plastic films such as a polyethylene terephthalate film, rubber plates or composite plates or films thereof. The surface of the substrate may be coated with a primer layer for preventing halation or for other various purposes.

Various kinds of primers can be used for improving the adhesion between the substrate and the light-sensitive resin layer, for preventing halation, for dyeing images and/or for improving printing properties. Examples thereof include those obtained by hardening a variety of light-sensitive polymers through exposure to light prior to the application of a light-sensitive resin layer as disclosed in J.P. KOKAI No. Sho 60-22903; those obtained by thermally hardening epoxy resins as disclosed in J.P. KOKAI No. Sho 62-50760; those obtained by hardening gelatin as disclosed in J.P. KOKAI No. Sho 63-133151; and those obtained from urethane resins as disclosed in J.P.A. Nos. Hei 1-282270 and Hei 2-21072. Besides, a hardened film of casein can likewise be effectively used as a primer layer.

The primer layer may further comprise various additives. For instance, it may comprise a polymer for softening, such as polyurethanes, polyamides, styrene/butadiene rubbers, carboxylic acid-modified styrene/butadiene rubbers, acrylonitrile/butadiene rubbers, carboxyl-modified acrylonitrile/butadiene rubbers, polyisoprenes, acrylate rubbers, polyethylenes, chlorinated polyethylenes and/or chlorinated polypropylenes, which have a glass transition point of not more than room temperature. These polymers may be used in any amount. Alternatively, the primer layer may be formed from these polymeric additives per se so far as they can form a film. The primer layer may likewise comprise other additives such as dyes, pH indicators, printing out agents, photopolymerization initiators, auxiliary agents for adhesion (for instance, polymerizable monomers, diazo resins, silane coupling agents, titanate coupling agents and aluminum coupling agents), white pigments and silica powder. The primer layer is in general applied onto the surface of a substrate in an amount suitably ranging from 0.1 to 20 g/m² and preferably 1 to 10 g/m² (weighed after drying).

The light-sensitive resin layer used in the present invention comprises (1) at least one monomer represented by the foregoing Formula (I), (2) a photopolymerization initiator and (3) a polymeric compound having film-forming ability. The light-sensitive resin layer may further comprise (4) an ethylenically unsaturated group-containing monomer or oligomer other than those represented by Formula (I) as an optional component.

### Component (1): Monomer of Formula (I)

The bivalent connecting group L¹ to L⁴ s of Monomer (I) are, for instance, a substituted or unsubstituted alkylene group having 1 to 6 carbon atoms, a substituted or unsubstituted phenylene group, a substituted or unsubstituted aralkylene group, -E¹-O-E²-, -E³-S-E⁴-, -E⁵-CO-O-E⁶- and -E⁷-SO₂NH-E⁸- wherein E¹ to E⁸ each represents a group selected from the foregoing substituted or unsubstituted alkylene, phenylene and aralkylene groups. Preferred are alkylene groups having 1 to 6 carbon atoms, phenylene group, aralkylene groups and bivalent functional groups having at least one -O-. The monovalent functional group represented by M is a substituted or unsubstituted alkyl group having 1 to 6 carbon atoms, a substituted or unsubstituted phenyl group, a substituted or unsubstituted aralkyl group or a halogen atom. n represents an integer of not less than 1, but preferably ranges from 1 to 100 from the practical standpoint.

Specific examples of the monomers of Formula (I) include those listed in Table 1. These monomers may be used alone or in combination.

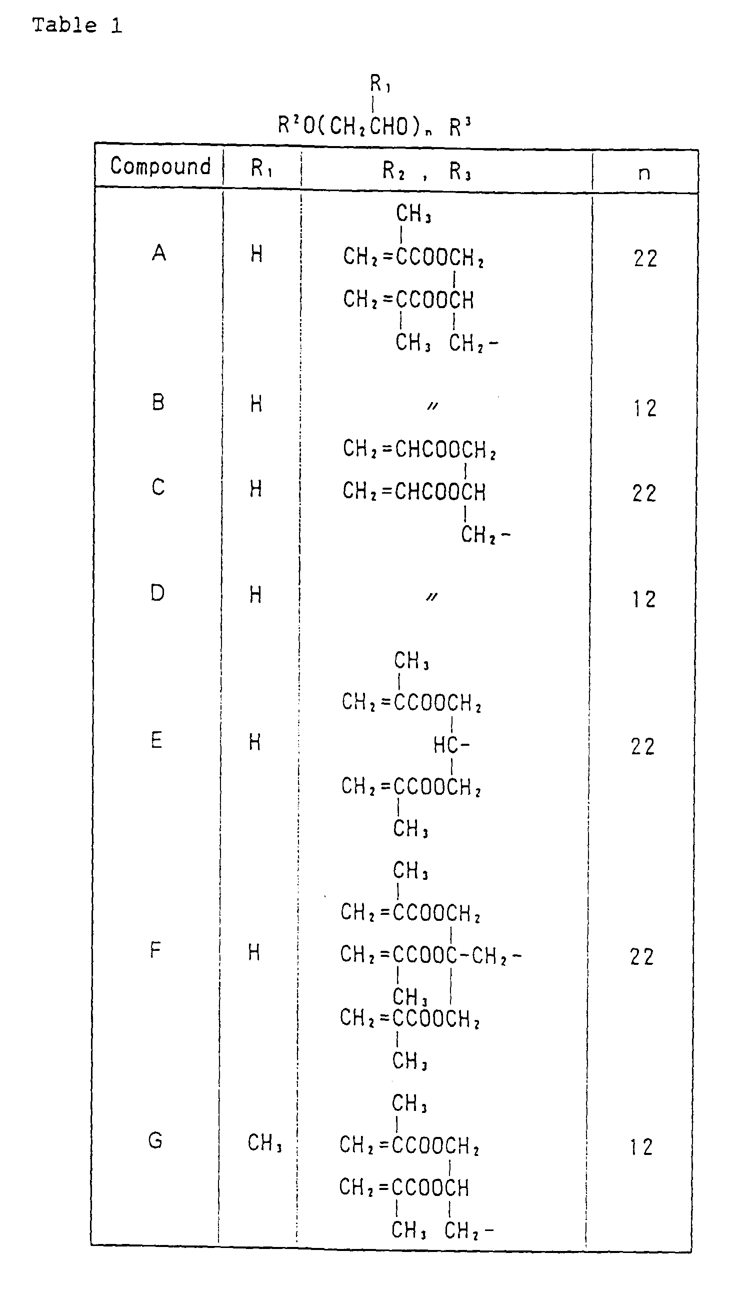

### Component (2): Photopolymerization Initiator

Photopolymerization initiators usable in the present invention include, for instance, vicinal polyketaldonyl compounds as disclosed in U.S. Patent No. 2,367,660; substituted or unsubstituted benzophenones and substituted or unsubstituted thioxanthones as described in J.P. KOKAI Nos. Sho 54-14489 and Hei 2-54269 and DE-A-4036 611, DE-A 4109523; α-carbonyl compounds as disclosed in U.S. Patent Nos. 2,367,661 and 2,367,670; acyloin ether compounds as disclosed in U.S. Patent No. 2,448,828; aromatic acyloin compounds which are substituted with a hydrocarbon group at the α-position as disclosed in U.S. Patent No. 2,722,512; polynuclear quinone compounds as disclosed in U.S. Patent Nos. 3,046,127 and 2,951,758; combinations of triarylimidazole dimers/p-aminophenyl ketone as disclosed in U.S. Patent No. 3,549,367; benzothiazole compounds as disclosed in U.S. Patent No. 3,870,524; combinations of benzothiazole compounds/trihalomethyl-s-triazine compounds as disclosed in U.S. Patent No. 4,239,850; acridine and phenazine compounds as disclosed in U.S. Patent No. 3,751,259; oxadiazole compounds as disclosed in U.S. Patent No. 4,212,970; trihalomethyl-s-triazine compounds having chromophoric groups as disclosed in U.S. Patent Nos. 3,954,475 and 4,189,323 and J.P. KOKAI Nos. Sho 53-133428, Sho 60-105667, Sho 62-58241 and Sho 63-153542; and benzophenone group-containing peroxyester compounds as disclosed in J.P. KOKAI Nos. Sho 59-197401 and Sho 60-76503. These polymerization initiators may be used alone or in combination. The photopolymerization initiators are used in an amount ranging from 0.1 to 20% by weight and preferably 1 to 10% by weight on the basis of the total weight of the light-sensitive composition.

### Component (3): Polymeric Compound Having Film-Forming Ability

The polymeric compounds having film-forming ability usable in the invention include, for instance, methacrylic acid copolymers, acrylic acid copolymers, crotonic acid copolymers, maleic acid copolymers, partially esterified maleic acid copolymers, acidic cellulose derivatives, polyvinyl pyrrolidones, polyethylene oxides, alcohol-soluble polyamides, polyesters, unsaturated polyesters, polyurethanes, polystyrenes, epoxy resins, phenoxy resins, polyvinyl butyrals, polyvinyl formals, polyvinyl chloride, polyvinyl alcohol, polyvinyl alcohols partially modified with acetal, water-soluble polyamides, water-soluble urethane polymers, gelatins and water-soluble cellulose derivatives.

It is also possible to use polymeric compounds having photopolymerizable or photocrosslinkable olefinically unsaturated double bonds on the side chains as the film-forming polymeric compounds. Examples of such polymeric compounds are allyl (meth)acrylate/(meth)acrylic acid/optional other addition polymerizable vinyl monomer copolymers and alkali metal and amine salts thereof as disclosed in J.P. KOKAI No. Sho 59-53836; products obtained by reacting (meth)acrylic acid chloride with hydroxyethyl (meth)acrylate/(meth)acrylic acid/alkyl (meth) acrylate copolymers and alkali metal and amine salts thereof as disclosed in J.P. KOKOKU No. Sho 59-45979; maleic anhydride copolymers to which pentaerythritol triacrylate is added through half-esterification and alkali metal and amine salts thereof as disclosed in J.P. KOKAI No. Sho 59-71048; styrene/maleic anhydride copolymers to which monohydroxyalkyl (meth)acrylate, polyethylene glycol mono(meth)acrylate or polypropylene glycol mono(meth)acrylate is added through half-esterification and alkali metal and amine salts thereof; methacrylic acid copolymers or crotonic acid copolymers whose carboxyl groups are partially reacted with glycidyl (meth) acrylate and alkali metal and amine salts thereof; products obtained by reacting hydroxyalkyl (meth)acrylate copolymers, polyvinyl formal or polyvinyl butyral with maleic anhydride or itaconic anhydride and alkali metal and amine salts thereof; products obtained by reacting hydroxyalkyl (meth)acrylate/(meth) acrylic acid copolymers with a 1:1 adduct of 2,4-tolylene diisocyanate/hydroxyalkyl (meth)acrylate and alkali metal and amine salts thereof; (meth)acrylic acid copolymers which are partially reacted with allyl glycidyl ether and alkali metal and amine salts thereof as disclosed in J.P. KOKAI No. Sho 59-53836; vinyl (meth)acrylate/(meth)acrylic acid copolymers and alkali metal and amine salts thereof; allyl (meth) acrylate/sodium styrenesulfonate copolymers; vinyl (meth) acrylate/sodium styrenesulfonate copolymers; allyl (meth) acrylate/acrylamide/sodium 1,1-dimethylethylenesulfonate copolymers; vinyl (meth)acrylate/acrylamide/sodium 1,1-dimethylethylenesulfonate copolymers; 2-allyloxyethyl methacrylate/methacrylic acid copolymers; and 2-allyloxyethyl methacrylate/2-methacryloxyethyl hydrogen succinate copolymers. These polymeric compounds may be used alone or in combination. The light-sensitive composition may comprise the polymeric compound in an amount ranging from 30 to 99% by weight and preferably 50 to 97% by weight on the basis of the total weight of the light-sensitive composition.

### Optional Component (4): Ethylenically Unsaturated Group-Containing Monomers and Oligomers Other Than Those Represented by Formula (I)

The light-sensitive layer or composition used in the invention may optionally comprise an ethylenically unsaturated group-containing monomer or oligomer other than those represented by Formula (I), which is, for instance, a monomer or oligomer carrying at least one photopolymerizable (meth) acrylate or allyl group. Specific examples thereof are as follows:
(A) (Meth)acrylates of alcohols such as ethanol, propanol, hexanol, octanol, cyclohexanol, glycerin, trimethylolpropane and pentaerythritol;
(B) Reaction products of amines, for instance, methylamine, ethylamine, butylamine, benzylamine, ethylenediamine, hexylenediamine, diethylenetriamine, hexamethylenediamine, xylylenediamine, dimethylamine, diethylamine, ethanolamine, diethanolamine and aniline with glycidyl acrylate, allyl glycidyl or glycidyl methacrylate;
(C) Reaction products of carboxylic acids, for instance, acetic acid, propionic acid, benzoic acid, acrylic acid, methacrylic acid, succinic acid, maleic acid, phthalic acid, tartaric acid and citric acid with glycidyl acrylate, glycidyl methacrylate, allyl glycidyl or tetraglycidyl m-xylylenediamine;
(D) Amide derivatives, for instance, acrylamide, methacrylamide, N-methylolacrylamide and methylenebisacrylamide; and
(E) Reaction products of epoxy compounds with (meth)acrylic acid.

Specific examples thereof include urethane acrylates as disclosed in J.P. KOKOKU Nos. Sho 48-41708 and Sho 50-6043 and J. P. KOKAI No. Sho 51-37193; polyester acrylates as disclosed in J.P. KOKAI No. Sho 48-64183 and J.P. KOKOKU Nos. Sho 49-43191 and Sho 52-30490; polyfunctional (meth)acrylates such as epoxy acrylates obtained through reactions of epoxy resins and (meth) acrylic acid; and N-methylolacrylamide derivatives as disclosed in U.S. Patent No. 4,540,649. Furthermore, it is also possible to use those described in Bulletin of Adhesives Society of Japan, 1984,20, No. 7, pp. 300-308 as photohardenable monomers and oligomers. In the polyfunctional monomers, the unsaturated group may comprise any combination of acryl, methacryl and allyl groups. These monomers and oligomers may be used alone or in combination.

The light-sensitive composition may comprise the monomers and oligomers of Components (1) and (4) in an amount ranging from 1 to 70% by weight, preferably 3 to 60% by weight on the basis of the total weight of the composition. Moreover, the weight ratio, Component (1)/Component (4), ranges from 100:0 to 20:80 and preferably 80:20 to 40:60.

### Other Components

The light-sensitive resin layer may preferably comprise a heat polymerization inhibitor and preferred examples thereof include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol) and 2-mercaptobenzimidazole.

The light-sensitive resin layer may further comprise dyes or pigments for coloring the light-sensitive resin layer and printing out agent such as pH indicators or leuco dyes.

The light-sensitive resin layer may optionally comprise a small amount of a silicone compound such as polydimethylsiloxane, methylstyrene-modified polydimethylsiloxane, olefin-modified polydimethylsiloxane, polyether-modified polydimethylsiloxane, silane coupling agents, silicone diacrylate and silicone dimethacrylate depending on purposes.

The light-sensitive composition may comprise a silicon atom-containing surfactant and/or a fluorine atom-containing surfactant for improving the coating properties of the resulting composition.

Further, a diazo resin may be incorporated into the light-sensitive composition for improving the adhesion between the light-sensitive resin layer and the primer layer.

These other components may be added to the light-sensitive composition in an amount of not more than 10% by weight on the basis of the total weight of the composition.

It is also possible to optionally incorporate, into the light-sensitive composition, silica powder or hydrophobic silica powder whose surface is treated with a (meth)acryloyl and/or allyl group-containing silane coupling agent in an amount of not more than 50% by weight on the basis of the total weight of the light-sensitive composition for enhancing the adhesion to the silicone rubber layer subsequently applied onto the light-sensitive resin layer.

The foregoing light-sensitive composition is dissolved in a proper solvent selected from the group consisting of 2-methoxyethanol, 2-methoxyethyl acetate, propylene glycol methylethyl acetate, methyl lactate, ethyl lactate, propylene glycol monomethyl ether, methanol, ethanol, methyl ethyl ketone, water and mixture thereof and then applied onto the surface of a substrate. The coated amount of the composition in general ranges from about 0.1 to 20 g/m², preferably 0.5 to 10 g/m² (weighed after drying).

The silicone rubber layer which is crosslinked through the addition reaction of ≡ Si-H groups and -CH=CH- groups used in the invention can be obtained by reacting a polyvalent hydrogenorganopolysiloxane with a polysiloxane having at least two -CH=CH- bonds in the molecule and is desirably those obtained by hardening and crosslinking a composition containing the following components:
(i) 100 parts by weight of an organopolysiloxane having at least two alkenyl groups (preferably vinyl groups) directly bonded to silicon atoms in the molecule;
(ii) 0.1 to 1000 parts by weight of an organohydrogenpolysiloxane having at least two ≡Si-H groups in the molecule; and
(iii) 0.00001 to 10 parts by weight of an addition catalyst.

The alkenyl group of Component (i) may be present either at the ends or in the middle of the molecular chain. Component (i) may have organic groups other than the alkenyl groups, such as substituted or unsubstituted alkyl and/or aryl groups. Component (i) may further comprise a trace amount of hydroxyl groups.

Component (ii) forms a silicone rubber layer through the reaction with Component (i), but it simultaneously serves to impart adhesion to the light-sensitive layer to the resulting silicone rubber layer. The hydrogen atom of Component (i) may be present either at the ends or in the middle of the molecular chain. Component (ii) may have organic groups in addition to the hydrogen atoms, such as substituted or unsubstituted alkyl and/or aryl groups. It is preferred that 60% or more of the total organic groups of Components (i) and (ii) be methyl groups from the viewpoint of the improvement in the ink repellency of the resulting silicone rubber layer. The molecular structures of Components (i) and (ii) may be linear, cyclic or branched ones. Either of Components (i) and (ii) preferably has a molecular weight of more than 1000 and more preferably the molecular weight of Component (i) is greater than 1000 for imparting good physical properties to the resulting silicone rubber layer.

Specific examples of Component (i) include α, ω-divinylpolydimethylsiloxane and methylvinylsiloxane/dimethylsiloxane copolymer having methyl groups at both ends and examples of Component (ii) include polydimethylsiloxane having methyl groups at both ends, α, ω-dimethylpolymethylhydrogensiloxane, methylhydrogensiloxane/dimethylsiloxane copolymer having methyl groups at both ends and cyclic polymethylhydrogensiloxane.

The addition reaction catalysts of Component (iii) may arbitrarily be selected from those known ones, but preferred are platinum compounds. Examples of platinum compounds include elemental platinum, platinum chloride, chloroplatinic acid and olefin-coordinated platinum. The silicone rubber composition may further comprise crosslinking inhibitors such as vinyl group-containing organopolysiloxanes, e.g., tet racyclo(methylvinyl)siloxane; carbon-carbon triple bond-containing alcohols, acetone, methyl ethyl ketone, methanol, ethanol and propylene glycol monomethyl ether for controlling the hardening rate of the composition.

These silicone rubber composition undergoes addition reaction as soon as the foregoing three components are mixed together and accordingly hardening thereof is initiated. In this respect, the hardening rate is rapidly increased as the temperature increases. The composition is preferably hardened within a temperature range which does not exert any detrimental effect on the properties of the substrate and the light-sensitive resin layer and the composition is maintained at a high temperature till it is completely hardened, in order to extend the pot life of the composition from mixing of these components till the complete hardening, i.e., the formation of the final rubber layer, to reduce the hardening time thereof on the light-sensitive layer and to ensure stable adhesion to the light-sensitive resin layer.

The silicone rubber composition may further comprise, in addition to the foregoing components, a known adhesion-imparting agent such as an alkenyltrialkoxysilane, a hydroxyl group-containing organopolysiloxane which is a component for condensed silicone rubber layer and/or hydrolyzable functional group-containing silane (or siloxane). Further, it may comprise known fillers such as silica for improving the strength of the resulting rubber layer.

The silicone rubber layer serves as a printing ink-repellent layer. As to the thickness of the silicone rubber layer, if the layer is too thin, the ink repellency thereof is impaired and the layer is easily damaged, while if it is too thick, the developability of the resulting PS plate is lowered. Therefore, the amount thereof to be applied suitably ranges from 0.5 to 5 g/m², preferably 1 to 3 g/m² (weighed after drying).

The addition type silicone rubber composition used in the invention is relatively slightly affected by humidity during hardening, can be hardened within a short period of time and easily provide silicone rubber layers having uniform physical properties. The condensed silicone rubber composition causes insufficient hardening depending on crosslinking agents used if a carboxylic acid is present in the light-sensitive resin layer, while the addition type silicone rubber composition is sufficiently hardened even if the light-sensitive layer comprises a carboxylic acid. If the addition type silicone rubber composition is adopted, a carboxylic acid may be incorporated into the light-sensitive layer. Therefore, the resulting PS plate can be developed with a developer mainly comprising water or an alkaline water and this accordingly makes the design of a lithographic printing plate easy. In the PS plate requiring no dampening water explained above, various other silicone rubber layers may further be applied onto the foregoing silicone rubber layer and the PS plate may comprise an adhesive layer between the light-sensitive resin layer and the silicone rubber layer for improving the adhesion therebetween and for preventing the poisoning of the catalyst present in the silicone rubber composition.

The PS plate may likewise comprise a transparent polymer layer for protecting the surface of the silicone rubber layer. The transparent polymer layer may be formed by, for instance, laminating the silicone rubber layer with a polymer film such as a polyethylene, polypropylene, polyvinyl chloride, polyvinylidene chloride, polyvinyl alcohol, polyethylene terephthalate or cellophane film or coating the surface of the silicone rubber layer with one of the foregoing polymeric compounds. These film may be oriented before application thereof or may be matted for the improvement of adhesion under vacuum to a printing frame during imagewise exposure to light.

The PS plate requiring no dampening water according to the present invention is first exposed to light through an original transparency and then developed with a developer capable of dissolving or swelling a part or whole of the light-sensitive resin layer in image portion (unexposed portion) or a developer capable of swelling the silicone rubber layer in the image portion. In this respect, both light-sensitive resin layer and silicone rubber layer or only the silicone rubber layer may be removed depending on the intensity of the developer used.

Any known developers for PS plates requiring no dampening water can be used in the present invention. Examples of preferred developers include aliphatic hydrocarbons such as hexane, heptane, "Isopar E, H, G" (trade names of aliphatic hydrocarbons available from ESSO Chemical Company), gasoline and kerosine; aromatic hydrocarbons such as toluene and xylene; and halogenated hydrocarbons such as trichloroethylene, to which the following polar solvents are added or polar solvents per se.
· Alcohols such as methanol, ethanol, propanol, benzyl alcohol, ethylene glycol monophenyl ether, 2-methoxyethanol, 2-ethoxyethanol, carbitol monoethyl ether, carbitol monomethyl ether, triethylene glycol monoethyl ether, propylene glycol monomethyl ether, propylene glycol monoethyl ether, dipropylene glycol monomethyl ether, polyethylene glycol monomethyl ether, propylene glycol, polypropylene glycol, triethylene glycol and tetraethylene glycol;
· Ketones such as acetone and methyl ethyl ketone;
· Esters such as ethyl acetate, methyl lactate, ethyl lactate, butyl lactate, propylene glycol monomethyl ether acetate, carbitol acetate, dimethyl phthalate and diethyl phthalate;
· Other Polar Solvents such as triethyl phosphate and tricresyl phosphate.

It is also possible to use, as developers, the foregoing organic solvent developers to which water is added; those obtained by solubilizing the foregoing oganic solvents in water with the aid of surfactants; or these developers containing water to which an alkali agent such as sodium carbonate, monoethanolamine, diethanolamine, triethanolamine, sodium silicate, potassium silicate, sodium hydroxide, potassium hydroxide or sodium borate, as well as tap water and alkaline water per se.

The developers may comprise a dye such as Crystal Violet, Victoria Pure Blue or Astrazone Red for simultaneously developing the PS plate and dyeing the resulting images.

The development of the PS plate can be performed by any known methods, for instance, by rubbing the plate surface with a developing pad containing the foregoing developer or by pouring a developer onto the plate surface and then rubbing the surface with a developing brush. Thus, the silicone rubber layer and the light-sensitive layer on the image portion are removed, the surface of the substrate of the primer layer is exposed and the exposed surface serves as an ink-receiving part. Alternatively, only the silicone rubber layer on the image portion is removed by the development, the light-sensitive resin layer is thus exposed and serves as an ink-receiving part.

As has been explained above in detail, the PS plate requiring no dampening water has a layer structure which comprises a substrate provided thereon with, in order, a light-sensitive layer and a silicone rubber layer and the light-sensitive resin layer comprises a monomer having 4 to 6 functionalities inclusive of an ethylene oxide or propylene oxide group, a film-forming polymeric compound and a photopolymerization initiator. Therefore, the PS plate of the invention is excellent in sensitivity and developability.

The present invention will hereunder be explained in more detail with reference to the following Preparation Examples and non-limitative working Examples and the effects practically achieved by the invention will also be discussed in detail in comparison with Comparative Examples.

### Preparation Example

Compound A was prepared according to the following reaction scheme:

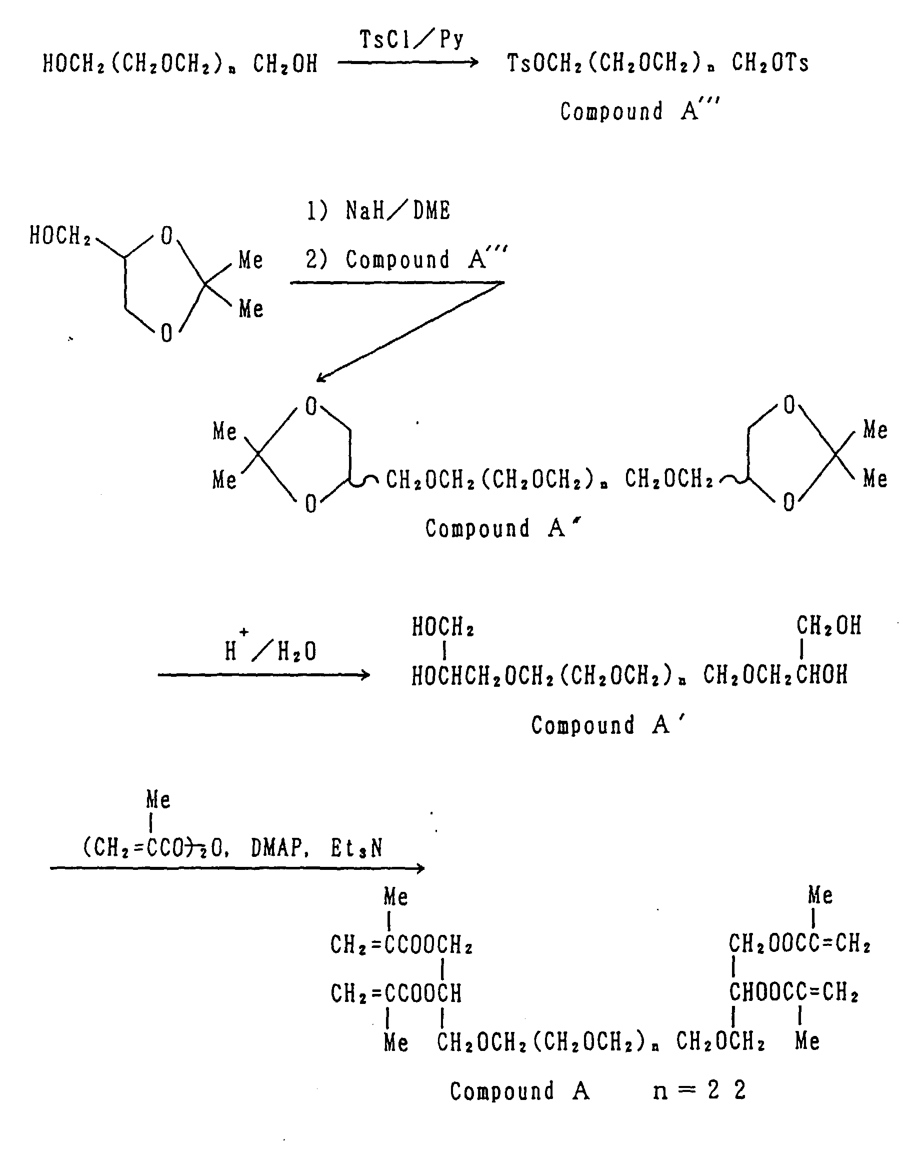

### Preparation of Compound A'''

There was dissolved 96 g (0.5 mole) of p-toluenesulfonyl chloride in 300 ml of pyridine and then 200 g (0.2 mole) of polyethylene glycol 1000 (available from Wako Pure Chemical Industries, Ltd.) was added to the resulting solution at a temperature of not more than 8°C over 2 hours. After the addition, the reaction mixture was stirred for 6 hours to complete the reaction. Water was added to the reaction mixture, followed by extraction of the mixture with methylene chloride and removal of the solvent through distillation to give 210 g of Compound A'''.

### Preparation of Compound A''

To a solution obtained by dissolving 2.4 g (0.06 mole) of sodium hydroxide (purity 60%) in 100 ml of 1,2-dimethoxyethane (DME), there was dropwise added 7.93 g (0.06 mole) of 2,2-dimethyl-1,3-dioxolan-4-methanol in an ice bath. After the dropwise addition, 28 g (0.02 mole) of Compound A''' was dropwise added to the mixture followed by stirring at room temperature for one hour. The reaction mixture was washed with water, the resulting organic phase was extracted with methylene chloride and then dried. The solvent and the excess 2,2-dimethyl-1,3-dioxolan-4-methanol were distilled off to give 20 g of Compound A''.

### Preparation of Compound A'

Compound A'' (20 g) was hydrolyzed with 4 ml of a 6N HCl solution. After completion of the reaction, the hydrochloric acid solution was distilled off to give 18.6 g of Compound A'.

### Preparation of Compound A

Methacrylic anhydride (13.04 g; 0.085 mole) was dropwise added to a solution comprising 18.4 g of Compound A', 10.27 g (0.102 mole) of triethylamine and 1.24 g (0.01 mole) of N,N-dimethylaminopyridine at a temperature of not more than 20 °C. After the dropwise addition, the reaction mixture was stirred at 45 °C for one hour.

Then water was dropwise added to the mixture, which was stirred for 30 minutes and extracted with methylene chloride. The extract was washed with a 2N HCl solution and a saturated sodium bicarbonate aqueous solution and dried. The solvent was distilled off, the resulting residue was chromatographed using acetone as an eluent to give 18 g of Compound A.
- NMR (in CDCl₃ ):: δ(ppm): 1.93 (s, 12H), 3.64 (s, 88H), 3.66-3.71 (m, 4H), 4.27-4.42 (m, 4H), 5.25-5.35 (m, 2H), 5.56-5.58 (m, 4H), 6.09-6.11 (m, 4H).

### Examples 1 to 7 and Comparative Examples 1 to 4

An aluminum plate of JIS A1050 which had been degreased in the usual manner and had a thickness of 0.3 mm was immersed in a 1% aqueous solution of KBM 603 (available from Shin-Etsu Chemical Co., Ltd.) as an aminosilane coupling agent and then dried at room temperature. A primer solution having the following composition was applied onto the aluminum plate in an amount of 4 g/m² (weighed after drying) and dried and hardened at 140°C for 2 minutes.

| Primer Solution | |
|---|---|
| Component | Amount (part by weight) |
| Sanprene IB1700D (terminal hydroxyl group-containing thermoplastic polyurethane resin, 30% methyl ethyl ketone solution, available from Sanyo Chemical Industries, Ltd.) | 10 |
| Takenate D110N (polyfunctional isocyanate compound, 75% ethyl acetate solution, available from Takeda Chemical Industries, Ltd.) | 0.5 |
| TiO₂ | 0.1 |
| MCF 323 (fluorine atom-containing surfactant, 30% methyl isobutyl ketone solution, available from Dainippon Ink and Chemicals Inc.) | 0.03 |
| propylene glycol methyl ether acetate | 50 |
| methyl lactate | 20 |

A photopolymerizable light-sensitive solution having the following composition was applied onto the primer layer formed on the aluminum plate in an amount of 5 g/m² (weighed after drying) and dried at 100°C for one minute.

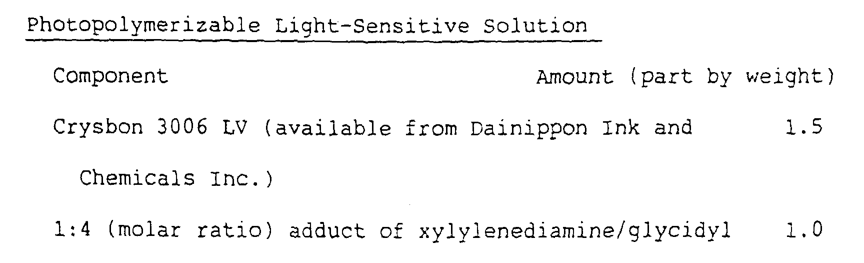

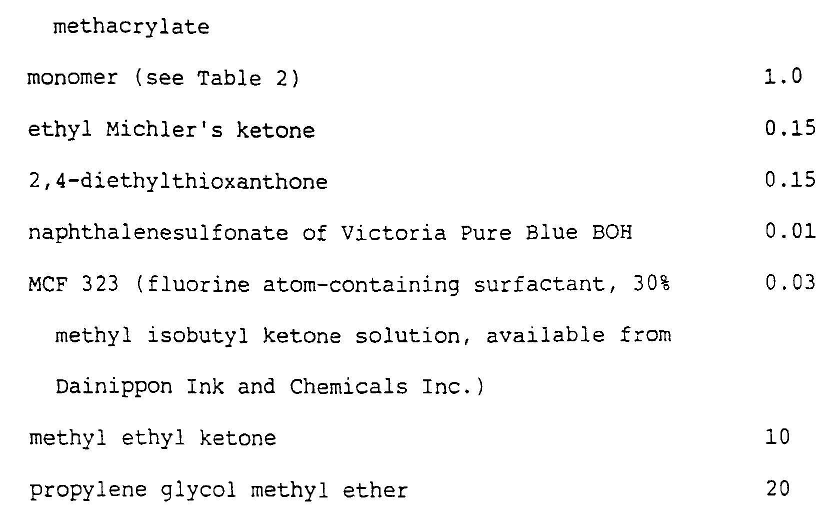

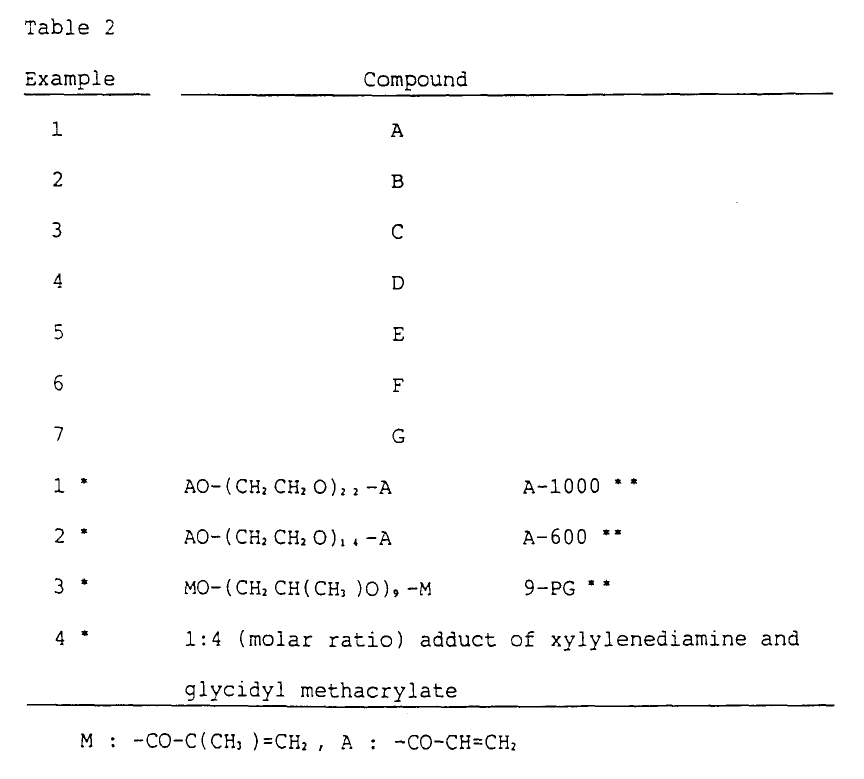

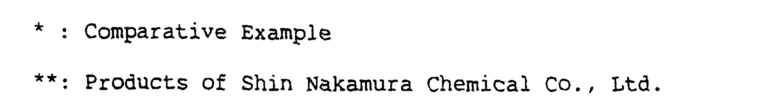

Then a solution for silicone rubber layer having the following composition was applied onto the photopolymerizable light-sensitive layer in an amount of 2.0 g/m² (weighed after drying) and then dried at 140°C for 2 minutes to give a silicone rubber layer.

| Solution for Silicone Rubber Layer | |
|---|---|
| Component | Amount (part by weight) |
| α, ω-divinylpolydimethylsiloxane (degree of polymerization = about 700) | 9 |
| (CH₃)₃Si-O-(Si(CH₃)₂-O)₃₀-(SiH(CH₃)-O)₁₀-Si(CH₃)₃ | 1.2 |
| polydimethylsiloxane (degree of polymerization = about 8000) | 0.5 |
| olefin-chloroplatinic acid | 0.2 |
| crosslinking inhibitor | 0.3 |
| Isopar G (available from ESSO Chemical Company) | 140 |

The silicone rubber layer thus formed was laminated with a one side-matted biaxially oriented polypropylene film (oxygen permeability: 4,57 x 10⁻¹³ m².s/Kg (4000 cc/m²/24hr/ atm) at 20 °C) so that the non-matted side thereof came in contact with the silicone rubber layer to give a PS plate requiring no dampening water.

A half tone dot positive film of 78,7 lines/cm (200 lines/inch) and a gray scale having an optical density difference of 0.15 were put on the PS plate and the resulting assembly was exposed to light for 30 counts using a vacuum exposure machine, FT261V UDNS ULTRA-PLUS FLIP TOP PLATE MAKER (available from Nu Arc Company) followed by peeling off of the laminate film and immersion of the plate in tripropylene glycol solution maintained at 40 °C for one minute. Then the silicone rubber layer on the unexposed portion was removed by rubbing the plate with a developing pad to give a lithographic printing plate requiring no dampening water. The resulting plate was examined for the gray scale sensitivity. Moreover, the developability was evaluated on the basis of the difference in gray scale sensitivity between the solid and clear portions. The smaller the difference, the greater the developability. The results are listed in Table 3.

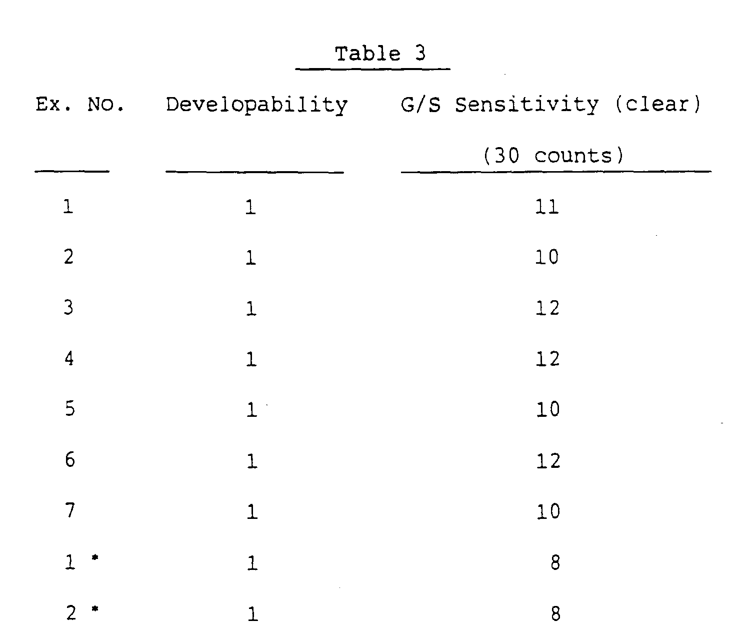

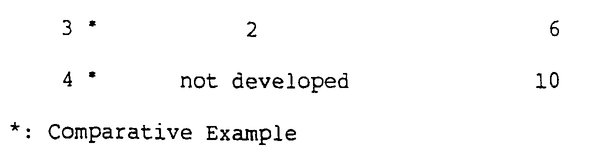

The data listed in Table 3 indicate that a PS plate requiring no dampening water having high sensitivity and good developability can be obtained by the use of the foregoing specific monomer.

## Claims

1. A presensitized plate requiring no dampening water for use in making a lithographic printing plate requiring no dampening water which comprises a substrate, a light-sensitive resin layer applied onto the substrate and a silicone rubber layer formed on the light-sensitive resin layer through an addition reaction of ≡ Si-H groups with -CH=CH- groups wherein the light-sensitive resin layer is formed from a light-sensitive composition comprising the following components:
1) at least one monomer represented by the following general formula (I):
R²O(CH₂CH(R¹)O) ₙ R³ (I)
wherein R¹ represents a hydrogen atom or a methyl group; R² and R³ may be the same or different and each represents a functional group selected from the group consisting of those represented by the following general formula (II): 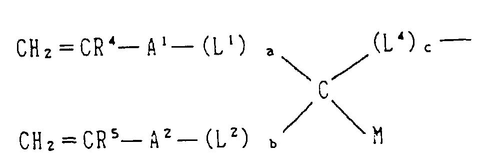 wherein, M represents a hydrogen atom, a monovalent functional group or a group: CH₂=CR⁶-A³-(L³) _{d} -; R⁴, R⁵ and R⁶ may be the same or different and each represents a hydrogen atom or a methyl group; A¹, A² and A³ may be the same or different and each represents -CO-O-, -CO-NH- or a substituted or unsubstituted phenylene group; L¹, L², L³ and L⁴ may be the same or different and each represents a bivalent connecting group; a, b, c and d may be the same or different and each represents 0 or 1 and n is an integer of not less than 1;
2) a photopolymerization initiator; and
3) a polymeric compound having film-forming ability.

2. The presensitized plate of claim 1 wherein, in the monomer of the general formula (I), the bivalent connecting group L¹ to L⁴ each is a substituted or unsubstituted alkylene group having 1 to 6 carbon atoms, a substituted or unsubstituted phenylene group, a substituted or unsubstituted aralkylene group, -E¹-O-E²-, -E³-S-E⁴, -E⁵-CO-O-E⁶- or -E⁷-SO₂NH-E⁸- wherein E¹ to E⁸ each represents a group selected from the foregoing substituted or unsubstituted alkylene, phenylene and aralkylene groups.

3. The presensitized plate of claim 1 wherein the photopolymerization initiator is used in an amount ranging from 0.1 to 20% by weight on the basis of the total weight of the light-sensitive composition.

4. The presensitized plate of claim 1 wherein the polymeric compound having film-forming ability is at least one member selected from the group consisting of methacrylic acid copolymers, acrylic acid copolymers, crotonic acid copolymers, maleic acid copolymers, partially esterified maleic acid copolymers, acidic cellulose derivatives, polyvinyl pyrrolidones, polyethylene oxides, alcohol-soluble polyamides, polyesters, unsaturated polyesters, polyurethanes, polystyrenes, epoxy resins, phenoxy resins, polyvinyl butyrals, polyvinyl formals, polyvinyl chloride, polyvinyl alcohol, polyvinyl alcohols partially modified with acetal, water-soluble polyamides, water-soluble urethane polymers, gelatins and water-soluble cellulose derivatives.

5. The presensitized plate of claim 1 wherein the light-sensitive composition comprises the polymeric compound in an amount ranging from 30 to 99% by weight on the basis of the total weight of the light-sensitive composition.

6. The presensitized plate of claim 1 wherein the light-sensitive composition further comprises, as component (4), at least one ethylenically unsaturated group-containing monomer and/or oligomer other than those represented by the general formula (I).

7. The presensitized plate of claim 6 wherein the ethylenically unsaturated group-containing monomer or oligomer other than those represented by the general formula (I) is at least one member selected from the group consisting of monomers and oligomers carrying at least one photopolymerizable (meth) acrylate or allyl group.

8. The presensitized plate of claim 1 wherein the total amount of the components (1) and (4) in the light-sensitive composition ranges from 1 to 70% by weight on the basis of the total weight of the composition.

9. The presensitized plate of claim 8 wherein the weight ratio, Component (1)/Component (4), ranges from 80 : 20 to 40 : 60.

10. The presensitized plate of claim 1 wherein the silicone rubber layer is obtained by hardening and crosslinking a composition containing the following components:
(i) 100 parts by weight of an organopolysiloxane having at least two alkenyl groups directly bonded to silicon atoms in the molecule;
(ii) 0.1 to 1000 parts by weight of an organohydrogenpolysiloxane having at least two ≡ SI-H groups in the molecule; and
(iii) 0.00001 to 10 parts by weight of an addition catalyst.

## Patentansprüche

1. Vorsensibilisierte Platte, die kein Befeuchtungswasser erfordert, zur Verwendung bei der Herstellung einer lithographischen Druckplatte, die kein Befeuchtungswasser erfordert und die einen Träger, eine lichtempfindliche Harzschicht, die auf den Träger aufgetragen ist, und eine Silikonkautschukschicht, die auf der lichtempfindlichen Harzschicht durch eine Additionsreaktion der ≡Si-H-Gruppen mit den -CH=CH-Gruppen gebildet wird, umfaßt, wobei die lichtempfindliche Harzschicht aus einer lichtempfindlichen Zusammensetzung gebildet wird, die die folgenden Bestandteile umfaßt:
1) mindestens ein Monomer der folgenden allgemeinen Formel (I):
R²O(CH₂CH(R¹)O)ₙ R³ (I)
in der R¹ ein Wasserstoffatom oder eine Methylgruppe bedeutet, R² und R³ gleich oder verschieden sein können und jeweils eine funktionelle Gruppe bedeuten, die aus der Gruppe, die aus den funktionellen Gruppen der folgenden allgemeinen Formel (II) 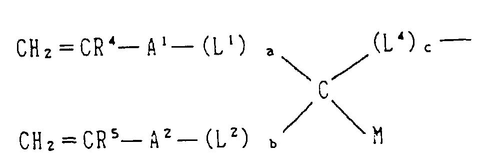 besteht, ausgewählt ist, in der M ein Wasserstoffatom, eine einwertige funktionelle Gruppe oder eine Gruppe: CH₂=CR⁶-A³-(L³)_{d}- bedeutet, R⁴, R⁵ und R⁶ gleich oder verschieden sein können und jeweils ein Wasserstoffatom oder eine Methylgruppe bedeuten, A¹, A² und A³ gleich oder verschieden sein können und jeweils einen Rest -CO-O- oder -CO-NH- oder eine substituierte oder unsubstituierte Phenylengruppe bedeuten, L¹, L², L³ und L⁴ gleich oder verschieden sein können und jeweils eine zweiwertige Verbindungsgruppe bedeuten, a, b, c und d gleich oder verschieden sein können und jeweils 0 oder 1 bedeuten und n eine ganze Zahl von nicht weniger als 1 ist,
2) einen Photopolymerisationsstarter und
3) eine polymere Verbindung mit Filmbildungsvermögen.

2. Vorsensibilisierte Platte nach Anspruch 1, wobei in dem Monomer der allgemeinen Formel (I) die zweiwertige Verbindungsgruppe L¹ bis L⁴ jeweils ein substituierter oder unsubstituierter Alkylenrest mit 1 bis 6 Kohlenstoffatomen, eine substituierte oder unsubstituierte Phenylengruppe, ein substituierter oder unsubstituierter Aralkylenrest oder ein Rest -E¹-O-E²-, -E³-S-E⁴-, -E⁵-CO-O-E⁶- oder -E⁷-SO₂-NH-E⁸- ist, wobei E¹ bis E⁸ jeweils eine Gruppe bedeuten, die aus den vorstehend genannten substituierten oder unsubstituierten Alkylen-, Phenylen- und Aralkylenresten ausgewählt ist.

3. Vorsensibilisierte Platte nach Anspruch 1, wobei der Photopolymerisationsstarter in einer Menge, die im Bereich von 0,1 bis 20 Gew.-%, bezogen auf das Gesamtgewicht der lichtempfindlichen Zusammensetzung liegt, verwendet wird.

4. Vorsensibilisierte Platte nach Anspruch 1, wobei die polymere Verbindung mit Filmbildungsvermögen mindestens eine Verbindung ist, die aus der Gruppe, die aus Methacrylsäurecopolymeren, Acrylsäurecopolymeren, Crotonsäurecopolymeren, Maleinsäurecopolymeren, teilweise veresterten Maleinsäurecopolymeren, sauren Cellulosederivaten, Polyvinylpyrrolidonen, Polyethylenoxiden, in Alkohol löslichen Polyamiden, Polyestern, ungesättigten Polyestern, Polyurethanen, Polystyrolen, Epoxyharzen, Phenoxyharzen, Polyvinylbutyralen, Polyvinylformalen, Polyvinylchlorid, Polyvinylalkohol, Polyvinylalkoholen, die teilweise mit Acetal modifiziert sind, wasserlöslichen Polyamiden, wasserlöslichen Urethanpolymeren, Gelatinen und wasserlöslichen Cellulosederivaten besteht, ausgewählt ist.

5. Vorsensibilisierte Platte nach Anspruch 1, wobei die lichtempfindliche Zusammensetzung die polymere Verbindung in einer Menge, die im Bereich von 30 bis 99 Gew.-%, bezogen auf das Gesamtgewicht der lichtempfindlichen Zusammensetzung liegt, umfaßt.

6. Vorsensibilisierte Platte nach Anspruch 1, wobei die lichtempfindliche Zusammensetzung ferner als einen Bestandteil (4), mindestens ein eine ethylenisch ungesättigte Gruppe enthaltendes Monomer und/oder Oligomer, die verschieden von denen der allgemeinen Formel (I) sind, umfaßt.

7. Vorsensibilisierte Platte nach Anspruch 6, wobei das eine ethylenisch ungesättigte Gruppe enthaltende Monomer oder Oligomer, die verschieden von denen der allgemeinen Formel (I) sind, mindestens eine Gruppe ist, die aus der Gruppe, die aus Monomeren und Oligomeren, die mindestens eine photopolymerisierbare (Meth)acrylat- oder Allylgruppe enthalten, besteht, ausgewählt ist.

8. Vorsensibilisierte Platte nach Anspruch 1, wobei die Gesamtmenge der Bestandteile (1) und (4) in der lichtempfindlichen Zusammensetzung im Bereich von 1 bis 70 Gew.-%, bezogen auf das Gesamtgewicht der Zusammensetzung liegt.

9. Vorsensibilisierte Platte nach Anspruch 8, wobei das Gewichtsverhältnis Bestandteil (1)/ Bestandteil (4) im Bereich von 80:20 bis 40:60 liegt.

10. Vorsensibilisierte Platte nach Anspruch 1, wobei die Silikonkautschukschicht durch Aushärten und Vernetzen einer Zusammensetzung, die die folgenden Bestandteile enthält, erhalten wird:
(i) 100 Gewichtsteile eines Organopolysiloxans mit mindestens zwei Alkenylresten, die direkt an die Siliciumatome im Molekül gebunden sind,
(ii) 0,1 bis 1000 Gewichtsteile eines Organohydrogenpolysiloxans mit mindestens zwei ≡Si-H-Gruppen im Molekül und
(iii) 0,00001 bis 10 Gewichtsteile eines Additionskatalysators.

## Revendications

1. Plaque présensibilisée ne nécessitant pas d'eau d'humidification pour une utilisation dans la fabrication d'une plaque d'impression lithographique ne nécessitant pas d'eau d'humidification qui comprend un substrat, une couche de résine photosensible appliquée sur le substrat et une couche de caoutchouc de silicone formée sur la couche de résine photosensible par l'intermédiaire d'une réaction d'addition de groupes ≡Si-H avec des groupes -CH=CH-, dans laquelle la couche de résine photosensible est formée à partir d'une composition photosensible comprenant les constituants suivants :
1) au moins un monomère représenté par la formule générale suivante (**I**) :
R²O (CH₂CH(R¹)O)ₙR³ (I)
dans laquelle R¹ représente un atome d'hydrogène ou un groupe méthyle; R² et R³ peuvent être identiques ou différents et représentent chacun un groupe fonctionnel choisi parmi ceux représentés par la formule générale suivante (**II**) : 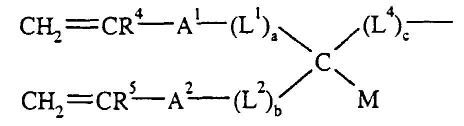 dans laquelle M représente un atome d'hydrogène, un groupe fonctionnel monovalent ou un groupe CH₂=CR⁶-A³-(L³)_{d}- ; R⁴, R⁵ et R⁶ peuvent être identiques ou différents et représentent chacun un atome d'hydrogène ou un groupe méthyle ; A¹, A², et A³ peuvent être identiques ou différents et représentent chacun -CO-O-, -CO-NH- ou un groupe phénylène substitué ou non substitué; L¹, L², L³ et L⁴ peuvent être identiques ou différents et représentent chacun un groupe bivalent de raccordement; a, b, c, et d, peuvent être identiques ou différents et représentent chacun 0 ou 1 et n est un nombre entier qui n'est pas inférieur à 1;
2) un initiateur de photopolymérisation; et
3) un composé polymère ayant une aptitude à former un film.

2. Plaque présensibilisée selon la revendication 1, dans laquelle dans le monomère de la formule générale (**I**) le groupe bivalent de raccordement L¹ à L⁴ est à chaque fois un groupe alkylène substitué ou non substitué ayant de 1 à 6 atomes de carbone, un groupe phénylène substitué ou non substitué, un groupe aralkylène substitué ou non substitué -E¹-O-E², -E³-S-E⁴, -E⁵-CO-O-E⁶ ou -E⁷-SO₂NH-E⁸- , où E¹ à E⁸ représentent chacun un groupe choisi parmi les groupes alkylène, phénylène et aralkylène substitués ou non substitués précédents.

3. Plaque présensibilisée selon la revendication 1, dans laquelle l'initiateur de photopolymérisation est utilisé dans une quantité comprise entre 0,1 et 20% en poids rapportés au poids total de la composition photosensible.

4. Plaque présensibilisée selon la revendication 1, dans laquelle le composé polymère ayant une aptitude à former un film est au moins un élément choisi parmi des copolymères d'acide méthacrylique, des copolymères d'acide acrylique, des copolymères d'acide crotonique, des copolymères d'acide maléique, des copolymères d'acide maléique partiellement estérifiés, des dérivés acidifères de cellulose, des poly(vinylpyrrolidones), des poly(oxydes d'éthylène), des polyamides solubles dans l'alcool, des polyesters, des polyesters insaturés, des polyuréthanes, des polystyrènes, des résines époxy, des résines phénoxy, des poly(butyrals de vinyle), des poly(formals de vinyle), du poly(chlorure de vinyle), du poly(alcool vinylique), des poly(alcools vinyliques) partiellement modifiés avec de l'acétal, des polyamides solubles dans l'eau, des polymères d'uréthane solubles dans l'eau, des gélatines et des dérivés de la cellulose solubles dans l'eau.

5. Plaque présensibilisée selon la revendication 1, dans laquelle la composition photosensible comprend le composé polymère dans une quantité comprise entre 30 et 99% en poids rapportés au poids total de la composition photosensible.

6. Plaque présensibilisée selon la revendication 1, dans laquelle la composition photosensible comprend en outre comme constituant (4) au moins un monomère et/ou un oligomère contenant un groupe éthyléniquement insaturé différent de ceux représentés par la formule générale (I).

7. Plaque présensibilisée selon la revendication 6, dans laquelle le monomère ou l'oligomère contenant un groupe éthyléniquement insaturé différent de ceux représentés par la formule générale (I) est au moins un élément choisi parmi des monomères et des oligomères portant au moins un groupe (méth)acrylate ou allyle photopolymérisable.

8. Plaque présensibilisée selon la revendication 1, dans laquelle la quantité totale des constituants (1) et (4) dans la composition photosensible est comprise entre 1 et 70% en poids rapportés au poids total de la composition.

9. Plaque présensibilisée selon la revendication 8, dans laquelle le rapport massique constituant (1)/constituant (4) est compris entre 80 : 20 et 40 : 60.

10. Plaque présensibilisée selon la revendication 1, dans laquelle la couche de caoutchouc de silicone est obtenue par durcissement et réticulation d'une composition contenant les constituants suivants :
(i) 100 parties en poids d'un organopolysiloxane ayant au moins deux groupes alcényle directement liés aux atomes de silicium dans la molécule ;
(ii) de 0,1 à 1 000 parties en poids d'un organohydrogénopolysiloxane ayant au moins deux groupes ≡Si-H dans la molécule ; et
(iii) de 0,00001 à 10 parties en poids d'un catalyseur d'addition.
